# EUROPÄISCHE PATENTSCHRIFT

(11) **EP 0 510 766 B1**
(45) Veröffentlichungstag und Bekanntmachung des Hinweises auf die Patenterteilung: **22.02.1995**
(21) Anmeldenummer: 92201113.5
(22) Anmeldetag: 21.04.1992
(51) Int. Cl.: H01J 9/04, C23C 16/50

(54) **Verfahren zur Herstellung eines Glühkathodenelements**
Method of manufacturing a thermionic cathode element
Procédé de fabrication d'un élément de cathode thermo-ionique

(30) Priorität: 22.04.1991 DE 4113085
(43) Veröffentlichungstag der Anmeldung: 28.10.1992
(73) Patentinhaber: Philips Patentverwaltung GmbH, 22335 Hamburg (DE); Philips Electronics N.V., 5621 BA Eindhoven (NL)
(72) Erfinder: Gärtner, Georg, Dr., W-5100 Aachen (DE); Janiel, Peter, W-5102 Würselen (DE)
(74) Vertreter: Hartmann, Heinrich, Dipl.-Ing.

(56) Entgegenhaltungen:
- EP-A- 0 324 523
- US-A- 4 533 852

## Beschreibung

Die Erfindung bezieht sich auf ein Verfahren zur Herstellung eines Glühkathodenelements aus einem mit Seltenerdoxid dotierten Refraktärmetall, wobei auf einem Substratkörper zunächst mehrere Teilschichten des Glühkathodenelements nacheinander mittels eines CVD-Verfahrens abgeschieden werden, und wobei im Verlaufe des CVD-Verfahrens dekarburierende Zwischenbehandlungen durchgeführt werden.

Ein derartiges Verfahren ist in der EP-A-0324523 beschrieben. Dabei wird bei der plasmaakrivierten CVD-Beschichtung (PCVD) einer Innenfläche eines Substratzylinders mit Wolfram und Scandiumoxid kodeponierter Kohlenstoff durch Plasmazwischenbehandlungen wieder entfernt.

Andererseits ist insbesondere bei thorierten Wolfram-Kathoden (vgl. EP-A-0204356) ein gewisser C-Gehalt erwünscht. W₂ C bewirkt, daß über die Reaktion ThO₂+2W₂C Th+4W+2CO metallisches Thorium freigesetzt wird und längs der Korngrenzen zur Oberfläche diffundiert und den dort abdampfenden und im wesentlichen monoatomaren Th-Film ergänzt.

Der Kohlenstoffgehalt bewirkt eine Versprödung des Glühkathodenelements, so daß es zur Vermeidung von Brüchen sehr vorsichtig behandelt werden muß.

Der Erfindung liegt die Aufgabe zugrunde, das Verfahren der eingangs genannten Art derart zu gestalten, daß gute Betriebseigenschaften des Kathodenelements erreicht werden, ohne daß die für die spätere Weiterbearbeitung erforderliche mechanische Festigkeit des Glühkathodenelements beeinträchtigt wird.

Die Lösung gelingt dadurch, daß nachfolgend das Glühkathodenelement durch eine Nachbehandlung karburiert wird.

Erfindungsgemäß werden CVD-Schichten im CVD-Reaktor dekarburiert, obgleich an sich ein gewisser Kohlenstoffanteil im Glühkathodenelement erwünscht ist. Erst dann, wenn das Glühkathodenelement keiner bruchgefährdenden mechanischen Beanspruchung mehr ausgesetzt zu werden braucht, vorzugsweise nach dessen Verbindung mit einem für den Einbau in eine Röhre vorgesehenen Tragkörper, wird eine Rekarburierung bewirkt. Nach dem Einbau in eine Hochfrequenzröhre oder auch in einen Glühkathodenteststand werden die vom Tragkörper gehaltenen Glühkathodenelemente in einer kohlenwasserstoffhaltigen Gasatmosphäre geglüht. Die dabei auftretende Versprödung ist nach schon erfolgtem Zusammenbau mit einem Tragkörper nicht mehr kritisch und ist bei Kathodenbetriebstemperaturen ab 2000 K ohnehin nicht mehr wirksam.

Eine praktisch vollständige Dekarburierung wird dadurch erreicht, daß auf dem Substratkörper alternierend Schichten aus einem Refraktärmetall, insbesondere Wolfram, und einem Seltenerdoxid, insbesondere ThOₓ, abgeschieden werden, und daß nach jeder Abscheidungsschicht des Seltenerdoxids eine dekarburierende Plasmazwischenbehandlung, insbesondere mittels Ar/O₂ durchgeführt wird.

Durch die Nachoxidation im O₂/Ar-Plasma eventuell gebildete schädliche W-Oxide können erforderlichenfalls dadurch beseitigt werden, daß nach Abscheidung einer Wolfram-Schicht eine H₂/Ar-Plasmazwischenbehandlung durchgeführt wird.

Das erfindungsgemäße Verfahren ist für beliebig geformte Glühkathodenelemente anwendbar. Besonders vorteilhaft geeignet ist es jedoch für die Herstellung besonders empfindlicher zylindrischer Glühkathodenelemente, welche auf der Innenwandung eines zylindrischen Substratkörpers abgeschieden werden. Dabei werden die Schichten vorzugsweise durch plasmaaktiviertes CVD (PCVD) abgeschieden.

Die Sprödigkeit von erfindungsgemäß hergestellten Glühkathodenelementen wird weiterhin dadurch verringert, daß in das Glühkathodenelement Rhenium kodeponiert wird. Die Kodeposition von Re mit Anteilen von einigen Prozent erfolgt gemeinsam mit W aus einem ReF₆/WF₆/H₂-Gemisch.

Es ist empfehlenswert, daß als Substratkörper ein Metallzylinder, insbesondere ein Kupferzylinder verwendet wird, dessen Innenfläche eine Oberflächenrauhigkeit von weniger als 1 um aufweist. Würde man beispielsweise dünne Substratzylinder durch Ausdrehen von dickeren Rohren herstellen und eine Riefenstruktur und Rauhigkeit im Bereich bis zu 10 um zulassen, würden sich die Unebenheiten als Abdruck auf dem Außenmantel des Glühkathodenelements abbilden und dort zu bruchempfindlichen Schwachstellen führen. Das wird vermieden, wenn ein dickwandiger Rohrabschnitt zunächst auf die erforderlichen Innenmaße bearbeitet und glatt poliert und danach außen bis auf die Solldicke abgetragen wird. Auch können die Cu-Substratzylinder direkt durch Galvanoformung auf einer entsprechend glatten verlorenen Form mit entsprechend geringer Oberflächenrauhigkeit 1 um hergestellt werden.

Eine die Festigkeit des Glühkathodenelements weiterhin erhöhende Maßnahme besteht darin, daß Anode und eine dazu axiale Kathode in Axialrichtung relativ zueinander hin- und herbewegt und relativ zueinander gedreht werden. Durch die damit ebenfalls mögliche Verringerung von in Umfangsrichtung entstehenden Dickenschwankungen der abgeschiedenen Schichten werden zusätzlich auch die Betriebseigenschaften des Glühkathodenelements verbessert.

Vorteilhaft wirkt sich auch eine an sich bekannte Maßnahme aus, daß das Glühkathodenelement nach der Fertigstellung der CVD-Schichten und/oder nach der Trennung vom Substratkörper einer mechanische Spannungen ausgleichenden Wärmebehandlung unterworfen wird. Dabei wird die Wärmebehandlung vorteilhaft im Rahmen der Kathodenaktivierung durchgeführt.

Wenn beispielsweise ein Cu-Substratzylinder vom Glühkathodenelement abgeschmolzen werden soll, wird ein Verbleiben von Cu-Teilen am Auflagebereich des Substratzylinders dadurch verhindert, daß axial unterhalb des Substratzylinders eine diesen berührende kreisförmige Auffangwanne vorgesehen wird.

Insbesondere bei der Herstellung eines Glühkathodenelements aus zahlreichen PCVD-Schichten, wie es für die Erfindung vorteilhaft ist, strebt man eine hohe Leistungsdichte des Plasmas und insbesondere der Gleichstromglimmentladung an. Das ist dadurch erreichbar, daß die beim PCVD-Verfahren durch Glimmentladung bewirkte Ionisierung durch ein Magnetfeld unterstützt wird.

Ein überlagertes axiales Magnetfeld, das durch eine außen z.B. über den zylindrischen Heizmantel gewickelte stromdurchflossene Spule, erforderlichenfalls eine supraleitende Spule, mit Feldstärken im Bereich von bis zu 1 Tesla erzeugt wird, bewirkt durch die Zyklotronbewegung der Elektronen und Ionen einen höheren Ionisierungsgrad und eine höhere Leistungsdichte im Plasma.

Erfindungsgemäß hergestellte Glühkathodenelemente können mit verschiedenen Formen gestaltet werden. Beispielsweise ist ein hohlzylinderförmiges Glühkathodenelement für eine Hochfrequenzröhre oder eine ähnliche Röhre geeignet. Erfindungsgemäße Glühkathodenelemente können auch die Form einer Scheibe oder eines Streifens haben. Solche Elemente können auch aus hohlzylinderförmigen Glühkathodenelemente ausgeschnitten werden, vorteilhaft mittels eines hochenergetischen Strahls. Flache oder scheibenförmige Glühkathodenelemente können in an sich bekannten Kathodenstrahlröhren für Röntgenanalyse (Festanodenröhre) oder für medezinische Drehanodenröntgenröhren eingesetzt werden. Es ist empfehlenswert, solche Glühkathodenelemente nach ihrer Fertigstellung und/oder nach ihrem Einbau in eine Röhre einer Spannungen ausgleichenden Wärmebehandlung zu unterziehen. Erfindungsgemäß hergestellte Glühkathodenelemente können Wendeln oder indirekt beheizte Flachkathoden bekannter Art ersetzen.

Die Erfindung wird anhand von in der Zeichnung dargestellten Ausführungsbeispielen näher erläutert:
- Fig. 1: zeigt eine Vorrichtung zur Durchführung von glimmentladungsaktivierten reaktiven Abscheidungen schematisch im Schnitt
- Fig. 2: zeigt einen Längsschnitt durch eine Drehanodenröntgenröhre mit einem erfindungsgemäß hergestellten Glühkathodenelement
- Fig. 3: zeigt einen Längsschnitt durch eine Röntgenröhre, welche vorzugsweise für die Röntgenanalyse Verwendung finden kann.

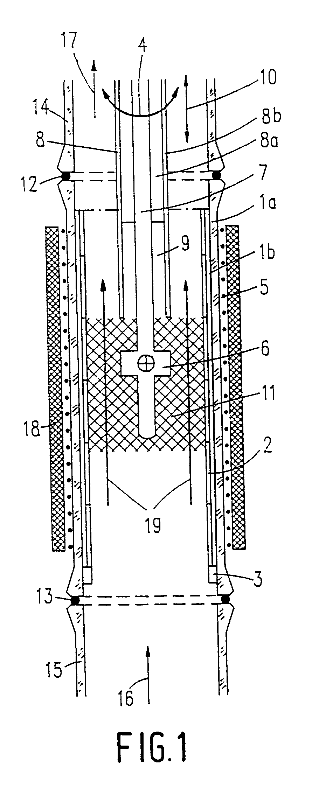

In Figur 1 ist schematisch ein Ausschnitt aus dem Bereich einer Reaktionskammer dargestellt. In einem Hüllrohr 1a, das z.B. aus Quarz besteht und einem Einsatz 1b aus Edelstahl aufweist, der zusammensteckbar sein kann, sind aus Kupfer bestehende Substratzylinder 2 auf einem Edelstahl- oder Cu-Ring 3 koaxial aufgestapelt. Der Ring 3 ist mit dem Minus-Pol einer nicht dargestellten Gleichspannungswelle verbunden.

Um das Hüllrohr 1a sind Heizwicklungen 5 gewickelt, welche die Substratzylinder 2 auf einer definierten Temperatur von beispielsweise 500°C oder mehr halten. Koaxial im Hüllrohr 1 befindet sich eine Innenelektrode, die als Anode 6 mit dem Pluspol der nicht dargestellten Gleichspannungsquelle verbunden ist. Die Anode 6 ist über einen nicht dargestellten Antrieb axial verschiebbar (Doppelpfeil 10) und drehbar (Doppelpfeil 4). Der aus Edelstahl bestehende Montagestab 7 für die Anode 6 ist von einer Isolationshülse 8a aus Al₂O₃-Keramik umhüllt. Kurz vor der Anode 6 beginnt ein etwa 1 mm breiter und mehrere Zentimeter tiefer Rundumspalt 9, der einen durchgehenden elektrisch leitenden Bewuchs verhindert. Die Isolationshülse 8a ist zumindest in der Nähe der Anode 6 von einer Außenhülse 8b umgeben, die aus einem Material besteht, das ein Abblättern von elektrisch leitendem Bewuchs verhindert. Ein derartiges Material ist z.B. Elektrographit. Die Baueinheit aus Anode 6, Montagestab 7 und Abschirmzylindern 8a und 8b ist axial bewegbar und drehbar. Zwischen der Anode 6 und den Substratzylindern 2 bildet sich eine Glimmentladung 11 aus.

Das Hüllrohr 1a ist über Dichtringe 12 und 13 zwischen Rohrabschnitten 14 und 15 gehalten. Die Gaszufuhr erfolgt in Richtung des Pfeils 16 auf der anodenabgewandten Seite. In Richtung des Pfeils 17 wird auf der Anodenseite das Gas entsorgt.

Mit 18 ist eine erforderlichenfalls supraleitende Erregerwicklung angedeutet, welche ein magnetisches Gleichfeld von bis zu 1 Tesla in Richtung der Pfeile 19 ausbildet.

Es wäre möglich, statt einer Drehbewegung der Anode 6 das Hüllrohr 1 innerhalb der Heizwicklung 5 drehbar zu lagern. Dann müßten die Dichtungen 12 und 13 derart gestaltet sein, daß sie eine Drehung des Hüllrohrs 1 während der Abscheidung von PCVD-Schichten auf die Innenfläche der Substratzylinder 2 zulassen. Die Stromzuführung zum Kupferring 3 müßte dann über einen Schleifkontakt erfolgen.

Nachdem auf die Substratzylinder 2 eine Vielzahl von W- und ThOₓ-Schichten abgeschieden wurde, wobei erfindungsgemäß dekarburierende Plasmazwischenbehandlungen mit Ar/O₂ erfolgen müssen, werden die Substratzylinder mit den an ihrer Innenfläche abgeschiedenen Glühkathodenelementen aus dem Reaktor entnommen. Vorzugsweise nach einer stabilisierenden Wärmebehandlung werden die beschichteten Kupfer-Substratzylinder 2 mit senkrechter Achse auf eine Ringwanne gestellt. Das Kupfer wird von den Glühkathodenelementen abgeschmolzen und von der Ringwanne aufgefangen. Die Ringwanne verhindert, daß die untere Ringkante des Glühkathodenelements mit Schmelzgut in Berührung bleibt.

Die noch kohlenstoffreien und deshalb weniger spröden Glühkathodenelemente können nach dem Zusammenbau mit einem für den Einbau in eine Röhre erforderlichen Haltekörper in einer Kohlenwasserstoff-Atmosphäre karburiert werden.

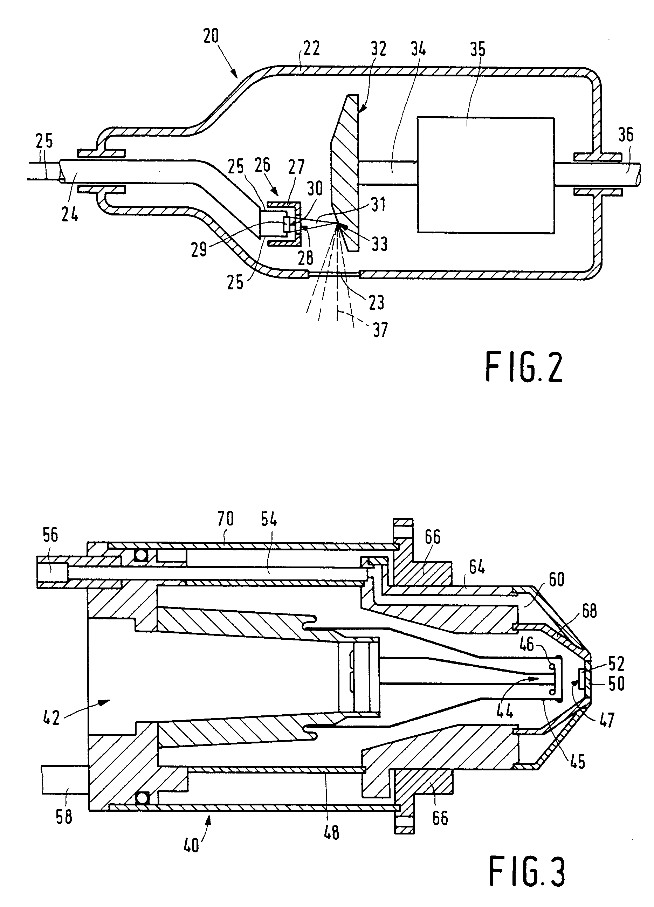

Eine Röntgenröhre mit einer Drehanode, insbesondere geeignet für medizinische Diagnosen, enthält gemäß Fig. 2 eine Wand 22 mit einem Auslaßfenster 23 für Röntgenstrahlung. Diese Wand 22 umgibt weiterhin eine Durchführungsöffnung 24 für Stromleiter 25 zur Kathode 26. Die Kathode 26 umfaßt im gewählten Beispiel eine Fokussier-Anode 27 mit einer Öffnung 28 für Elektronen, welche auf die Oberfläche der Drehanode 32 fokussiert werden. Dort werden Röntgenstrahlen erzeugt. Die Kathode umfaßt weiterhin ein Glühkathodenelement 29 gemäß der vorliegenden Erfindung, welches geeignet gestaltet und geformt ist, um einen steuerbaren dichten Elektronenstrahl 31 erzeugen zu können. Die emittierende Oberfläche 30 des Glühkathodenelements 29 ist in bevorzugter Weise flach gestaltet. Sie emittiert einen Elektronenstrahl 31, welcher in Richtung auf die Drehanode 32 beschleunigt wird und auf einen Brennfleck 33 auftrifft. Um eine Welle 34 wird die Drehanode 32 mittels eines Antriebssystems 35 gedreht, beispielsweise mit 9000 Umdrehungen pro Minute. Leitungszuführungen zur Drehanode 32 und zum Antriebssystem 35 werden durch die Passage 36 in der Wand 22 geführt. Infolge der Drehung der Drehanode 32 beschreibt der Brennfleck 33 eine Kreisbahn.

Fig. 3 zeigt eine andere Ausführungsform einer Röntgenröhre, welche insbesondere für die Röntgenanalyse geeignet ist. Ein Außengehäuse 40 umhüllt einen konischen Keramik-Grundkörper 42, eine Kathode 44 und ein ringförmig gestaltetes emissives Element 46. Mit Unterstützung des Anodenelements 45 wird ein konischer Elektronenstrahl gebildet und auf die Oberfläche 47 der Anode 52 fokussiert. Der Fokusfleck kann punktförmig oder ringförmig sein, entsprechend der für den jeweiligen Meßfall gewünschten günstigen Form.

Das ringförmige emittierende Element 46 ist als erfindungsgemäß hergestelltes Glühkathodenelement gestaltet und ermöglicht die Erzeugung dichter Elektronenstrahlen für eine lange Lebensdauer. Mit 48 ist eine zylindrische Wandung bezeichnet. An der Innenseite eines Auslaßfensters 50 für die Elektronenstrahlung ist die Anode 52 in Form einer Beschichtung mit Anoden-Werkstoff angeordnet. Beispielsweise besteht die Anode aus Chrom, Rhodium, Scandium oder einem anderen geeigneten Material. Zwischen der äußeren Gehäusewand und der inneren zylindrischen Wand 48 ist ein Kühlmittelweg 54 mit einem Einlaß 56, einem Auslaß 58 und einer Strömungsführung 60, welche das Auslaßfenster 50 umschließt, vorgesehen.

Das Gehäuse der Röntgenröhre ist umgeben von einer Einbauansatz 64 und einem Einbauflansch 66. Ein Strahlungsschirm 68 dient auch dazu, daß Kühlmittel zu führen. Die äußere Gehäusewand 70, an welcher das Kühlmittel entlanggeführt wird, hat eine geringe Wandstärke und unterstützt deshalb die Kühlwirkung.

## Patentansprüche

1. Verfahren zur Herstellung eines Glühkathodenelements aus einem mit Seltenerdoxid dotierten Refraktärmetall, wobei auf einem Substratkörper (2) zunächst mehrere Teilschichten des Glühkathodenelements nacheinander mittels eines CVD-Verfahrens abgeschieden werden, und wobei im Verlaufe des CVD-Verfahrens dekarburierende Zwischenbehandlungen durchgeführt werden,
dadurch gekennzeichnet, daß nachfolgend das Glühkathodenelement durch eine Nachbehandlung karburiert wird.

2. Verfahren nach Anspruch 1,
dadurch gekennzeichnet, daß auf dem Substratkörper (2) alternierend Teilschichten aus einem Refraktärmetall, und einem Seltenerdoxid abgeschieden werden, und daß nach Abscheidung jeder Teilschicht des Seltenerdoxids eine dekarburierende Plasmazwischenbehandlung durchgeführt wird.

3. Verfahren nach Anspruch 2,
dadurch gekennzeichnet, daß das Refraktärmetall Wolfram ist und nach Abscheidung einer Wolfram-Schicht eine H₂/Ar-Plasmazwischenbehandlung durchgeführt wird.

4. Verfahren nach einem der Ansprüche 1 oder 2,
dadurch gekennzeichnet, daß die Seltenerdoxid ThOₓ ist und eine Plasmazwischenbehandlung mittels Ar/O₂ durchgeführt wird.

5. Verfahren nach einem der Ansprüche 1 bis 4,
dadurch gekennzeichnet, daß die Teilschichten des Glühkathodenelements auf der Innenwand eines zylindrischen Substratkörpers (2) abgeschieden werden.

6. Verfahren nach einem der Ansprüche 1 bis 5,
dadurch gekennzeichnet, daß die Teilschichten durch plasmaaktivierte CVD (PCVD) abgeschieden werden.

7. Verfahren nach einem der Ansprüche 1 bis 6,
dadurch gekennzeichnet, daß eine Anode (6) und eine Kathode während der Abscheidung der Teilschichten relativ zueinander bewegt werden.

8. Verfahren nach einem der Ansprüche 1 bis 7,
dadurch gekennzeichnet, daß ein Glühkathodenelement vom Substratkörper getrennt und danach durch eine Nachbehandlung karburiert wird.

9. Verfahren nach einem der Ansprüche 1 bis 8,
dadurch gekennzeichnet, daß die beim PCVD-Verfahren durch Glimmentladung bewirkte Ionisierung durch ein Magnetfeld unterstützt wird.

10. Verfahren nach einem der Ansprüche 1 bis 9,
dadurch gekennzeichnet, daß in das Glühkathodenmaterial Rhenium kodeponiert wird.

11. Verfahren nach einem der Ansprüche 1 bis 10,
dadurch gekennzeichnet, daß das Glühkathodenelement nach Fertigstellung einer mechanische Spannungen ausgleichenden Wärmebehandlung unterworfen wird.

## Claims

1. A method of manufacturing a hot-cathode element from a rare-earth-oxide doped refractory metal, in which initially a plurality of sub-layers of the hot-cathode element are successively deposited on a substrate member (2) by means of a CVD process, and in which decarburizing intermediate treatments are executed in the course of the CVD process, characterized in that subsequently the hot-cathode element is carburized by an aftertreatment.

2. A method as claimed in Claim 1, characterized in that on the substrate member (2) sub-layers of a refractory metal and a rare-earth oxide are deposited in an alternating fashion, a decarburizing plasma intermediate treatment being performed after deposition of each rare-earth-oxide sub-layer.

3. A method as claimed in Claim 2, characterized in that the refractory metal is tungsten and that after deposition of a tungsten layer a H₂/Ar plasma intermediate treatment is performed.

4. A method as claimed in one of the Claims 1 or 2, characterized in that the rare-earth oxide is ThOₓ and that a plasma intermediate treatment is performed by means of Ar/O₂.

5. A method as claimed in any one of the Claims 1 to 4, characterized in that the sub-layers of the hot-cathode element are deposited on the inner wall of a cylindrical substrate member (2).

6. A method as claimed in any one of the Claims 1 to 5, characterized in that the sub-layers are deposited by plasma-activated CVD (PCVD).

7. A method as claimed in any one of the Claims 1 to 6, characterized in that an anode (6) and a cathode are moved relative to one another during the deposition of the sub-layers.

8. A method as claimed in any one of the Claims 1 to 7, characterized in that a hot-cathode element is separated from the substrate member and is subsequently carburized by an aftertreatment.

9. A method as claimed in any one of the Claims 1 to 8, characterized in that the ionization realized during the PCVD process by glow discharge is assisted by a magnetic field.

10. A method as claimed in any one of the Claims 1 to 9, characterized in that rhenium is co-deposited in the hot-cathode material.

11. A method as claimed in any one of the Claims 1 to 10, characterized in that after its manufacture the hot-cathode element is subjected to a thermal treatment eliminating mechanical stresses.

## Revendications

1. Procédé pour la fabrication d'un élément cathodique thermo-ionique en un métal réfractaire dopé avec un oxyde des terres rares, selon lequel plusieurs couches partielles de l'élément cathodique thermo-ionique sont déposées successivement sur un corps de substrat (2) à l'aide d'un procédé DCV et selon lequel des traitements intermédiaires de décarburation sont effectués au cours du procédé DCV, caractérisé en ce qu'ensuite l'élément cathodique thermo-ionique est carburé par un traitement ultérieur.

2. Procédé selon la revendication 1, caractérisé en ce que sur le corps de substrat (2) sont déposées des couches partielles alternantes en un métal réfractaire et un oxyde des terres rares et en ce qu'après dépôt de chaque couche partielle en oxyde des terres rares est effectué un traitement intermédiaire au plasma de décarburation.

3. Procédé selon la revendication 2, caractérisé en ce que le métal réfractaire est du tungstène et après le dépôt d'une couche en tungstène est effectué un traitement intermédiaire au plasma H₂/Ar.

4. Procédé selon l'une des revendications 1 ou 2, caractérisé en ce que l'oxyde des terres rares est ThOₓ et un traitement intermédiaire au plasma est effectué à l'aide de Ar/O₂.

5. Procédé selon l'une des revendications 1 à 4, caractérisé en ce que les couches partielles de l'élément cathodique thermo-ionique sont déposées sur la paroi intérieure d'un corps de substrat cylindrique (2).

6. Procédé selon l'une des revendications 1 à 5, caractérisé en ce que les couches partielles sont déposées par DCV activé au plasma (DCVP).

7. Procédé selon l'une des revendications 1 à 6, caractérisé en ce que lors du dépôt des couches partielles, une anode (6) et une cathode sont déplacées relativement l'une vers l'autre.

8. Procédé selon l'une des revendications 1 à 7, caractérisé en ce qu'un élément cathodique thermo-ionique est séparé du corps de substrat et ensuite carburé par un traitement ultérieur.

9. Procédé selon l'une des revendications 1 à 8, caractérisé en ce que l'ionisation provoquée par décharge par lueur pendant le procédé DCVP est soutenue par un champ magnétique.

10. Procédé selon l'une des revendications 1 à 9, caractérisé en ce que du rhénium est également déposé dans le matériau de cathode thermo-ionique.

11. Procédé selon l'une des revendications 1 à 10, caractérisé en ce qu'après l'achèvement l'élément cathodique thermo-ionique est soumis à un traitement thermique pour compenser les tensions mécaniques.
